# EUROPEAN PATENT SPECIFICATION

(11) **EP 0 831 155 B1**
(45) Date of publication and mention of the grant of the patent: **23.08.2000**
(21) Application number: 97118493.2
(22) Date of filing: 27.09.1993
(51) Int. Cl.: C23C 14/34

(54) **Method of manufacturing a diffusion-bonded sputtering target assembly**
Verfahren zur Herstellung eines diffusionsgebundenen Sputtertargetaufbaus
Méthode pour la production d'une assemblage de cible de pulvérisation lié par diffusion

(30) Priority: 29.09.1992 JP 28229792; 24.11.1992 JP 33489992; 07.12.1992 JP 35110692
(43) Date of publication of application: 25.03.1998
(62) Divisional of application: 93307621.8
(73) Proprietor: JAPAN ENERGY CORPORATION, Tokyo 105-0001 (JP)
(72) Inventor: Ohhashi, Tateo, Japan Energy Corporation, Kitaibaraki-shi, Ibaraki-ken (JP); Fukuyo, Hideaki, Japan Energy Corporation, Kitaibaraki-shi, Ibaraki-ken (JP); Sawamura, Ichiroh, Japan Energy Corporation, Kitaibaraki-shi, Ibaraki-ken (JP); Nakamura, Kenichirou, Japan Energy Corporation, Kitaibaraki-shi, Ibaraki-ken (JP); Fukushima, Atsushi, Japan Energy Corporation, Kitaibaraki-shi, Ibaraki-ken (JP); Nagasawa, Masaru, Japan Energy Corporation, Kitaibaraki-shi, Ibaraki-ken (JP)
(74) Representative: Swindell & Pearson

(56) References cited:
- EP-A- 0 374 931

## Description

### [Field of the invention]

This invention relates to a method of manufacturing a sputtering target assembly composed of a sputtering target and a backing plate featuring bonding a sputtering target and a backing plate by solid-phase diffusion bonding, with or without an insert or inserts placed therebetween.

By solid-phase diffusion bonding, a sputtering target exhibits excellent adhesion and bond strength to a backing plate while maintaining its structure and crystal characteristics including crystal gain size, crystal orientation etc. which it had before the diffusion bonding with no contamination possibly caused by the bonding process.

### [Background of the invention]

Sputtering targets serve as sputtering sources to form electrodes, gates, wirings, elements, protective films and the like of various semiconductor devices on substrates by sputtering operation. They usually take the form of disk-shaped plates. As accelerated particles impinge against a target surface, part of the atoms constituting the target is sputtered to the space by momentum exchange to deposit on an oppositely located substrate. Typical sputtering targets in use include Al and Al alloy targets, a refractory metal and its alloy (W, Mo, Ti, Ta, Zr, Nb, etc. and their alloys such as W-Ti) targets, and high-melting silicide (MoSiₓ, Wsiₓ, etc.) targets. The targets are usually used in the form of assembly integrally bonded with a backing material, known as a backing plate, which provides both support and cooling functions. A sputtering target assembly is mounted in a sputtering system, and the rear side of the backing plate is cooled to dissipate the heat that is generated in the target during sputtering operation. The backing plates in use today are made of metals and alloys with good thermal conductivities, such as oxygen-free copper (OFC), Cu alloys, Al alloys, stainless steels (SUS), and Ti and Ti alloys.

Heretofore, for the bonding of a sputtering target and a backing plate to constitute a sputtering target assembly, brazing method using a low-melting brazing material such as In or Sn alloy has been primarily employed. But, the brazing technique using a low-melting brazing material has the following disadvantages:
(1) The low melting point of brazing materials, 158 °C for In or 160-300 °C even for an Sn alloy, causes a sharp drop of the bond strength under shear as the service temperatures approaches its melting point. Specifically, the bond strength under shear at room temperature is less than 9.8 MPa (1 kg/mm²) for In and 19.6 - 39.2 MPa (2-4 kg/mm²) for even an Sn alloy which has relatively high strength. This combines with the low melting point of the brazing material to cause a sharp drop of the bond strength under shear upon temperature rise.
(2) With the brazing technique, 100% bonding with no un-bonded portions is difficult to achieve since the contraction upon solidification of the brazing material during the bonding process leaves pores (air gaps) behind along the bonded interfaces between the target and backing plate.

Consequently, the electric power to be provided for sputtering is limited to a low level. Also, when the system is loaded with greater sputtering power than specified or operated under inadequate cooling water control, troubles such as the separation of the target are caused due to a decrease in bond strength upon temperature rise of the target or melting of the brazing material.

The employment of a high-melting brazing material in place of the low-melting one requires a higher temperature for brazing, which sometimes affects the target quality adversely.

A recent tendency is toward the use of greater electric power for sputtering to improve the throughput for film forming by sputtering. In view of this, there is strong demand for a target which is capable of maintaining the bond strength above a predetermined level even at elevated temperatures.

Meanwhile, Japanese Patent Application Public Disclosure Nos. 143268/1992 and 143269/1992 disclosed targets and methods of manufacturing them which involve a process of integrally bonding a first metal member that serves as a sputtering material to a second metal member that serves as a support either directly or through the interposition of a spacer having a higher melting point than the first metal member. As regards the method of integrally bonding them together, explosive welding is primarily explained. Others referred to as employable are hot press, HIP, and hot roll methods. Taking the hot press method for example, it is described as comprising the steps of working and machining, e.g., an al-1%Si alloy as the first metal member (sputtering material) and oxygen-free copper as the second metal member (support), both to relatively simple shapes, and bonding the two members by hot pressing at 300-500°C for 60 minutes, whereby a diffusion layer of about 2 µm thickness is said to be formed, and thereafter machining the first and second metal members (sputtering material and support) thus bonded together to final configurations. It is also stated to the effect that alternatively the first and second metal members having been machined to desired shapes may be bonded by explosive welding.

### [Problems to be solved]

The methods described above involve high pressure bonding of the first and second metal members under very great impact or heavy load such as a explosive bonding, hot press, HIP, or hot roll technique. This process causes serious deformation of the first metal member to be sputtered (target material), and attendant increased internal strains and the change of crystal structure.

Particularly, the uniformity as of crystal size and crystal orientation of a target is destroyed resulting in different crystal grain diameters and crystal orientations on various locations of the target. As a result, the quantity of sputter from the target begins to vary from point to point which leads to variation of deposited film thickness and hence deposited film properties. This problem is recently pointed out that this is a matter of serious concern. Further, the contamination of surface layer of the target produced is severe and so the yield of target material to be finished to the final size is very poor. Although it is also stated in the above mentioned publication that the first and second metal members may be bonded by explosive bonding after they have been machined to desired configurations, in that case, deformation of the target material and attendant increased internal strains and the change of crystal structure, and surface layer contamination are inevitable as stated above.

Recently, target materials having melting points below 1000° C, e.g., aluminum or aluminum alloys, have rapidly come into use for the wirings or interconnections of semiconductor devices. These target materials in many cases are supplied as finished to final geometry with very high purity. Such relatively lower melting target materials are susceptible to larger damages of its crystal structure, sometimes accompanied with coarsening of grain size of the target material.

### [Object of the invention]

The present invention has for its object the development of a technique for bonding a target material finished to the final geometry or near net shape of the final geometry to a backing plate with a high strength while maintaining the uniformity of the crystal structure and imparting no deformative, degrading, or other unfavorable effect upon the target material itself.

### [Summary of the invention]

The present inventors have searched for a bonding method for target materials which inhibits the crystal characteristics such as crystal grain growth and causes little deformative or other adverse effects upon the material. As a result, it has now been found that solid-phase diffusion bonding with or without the use of an insert produces a far better bond than expected in their interfaces. The diffusion bonding, performed while maintaining a solid phase under a light load (a low strain rate) in a vacuum, gives high adhesion and high bond strength with no or very small deformation of the target material and with no un-bonded portions such as pores along the interfaces, while inhibiting the destruction of uniform crystal structure, the growth of grains, etc. which the target material had before the bonding.

The term Solid-phase diffusion bonding as used herein means a technique of bonding a target material and a backing plate with or without an insert or inserts sandwiched therebetween by diffusion along the interfaces under light heating and pressing conditions, whereby the two members are bonded while maintaining the solid phase rather than being melted, without causing unfavorable effects upon the target material including its grain growth and structure change.

Based upon this discovery, this invention provides a method of manufacturing a sputtering target assembly comprising a sputtering target and a backing plate characterised in that said sputtering target and backing plate are solid-phase diffusion-bonded with or without an insert or inserts interposed therebetween so as to have solid phase diffusion-bonded interfaces therebetween, said diffusion-bonded sputtering target substantially maintaining metallurgical characteristics and properties that the sputtering target had before it is diffusion-bonded to said backing plate.

It is convenient in explanation to divide target materials into ones having melting temperatures below and no less than 1000°C and separately discuss them.

There is described herein in a first aspect:
(1-1) a solid-phase diffusion-bonded sputtering target assembly characterised by being composed of a target material having a melting point below 1000°C, one or more insert, and a backing plate, said target material, said insert and said backing plate having solid-phase diffusion bonded interfaces formed therebetween, said target material having uniform crystal structural with a grain size not exceeding 250 µm; and
(1-2) a method of manufacturing a sputtering target assembly, said target material having a grain size not exceeding 250 µm characterised by solid-phase diffusion bonding of a target material of a given final shape having a melting point below 1000°C and a backing plate of a given final shape, with one or more inserts interposed therebetween, under a vacuum at a temperature between 150 and 300°C.

Typical of the target material consists of aluminum or an aluminum alloy. The insert typically consists of silver or a silver alloy, copper or copper alloy, or nickel or a nickel alloy.

There is described herein, in a second aspect:
(2-1) a solid-phase diffusion-bonded sputtering target assembly characterised by being composed of a target material having a melting point no less than 1000°C, one or more insert selected from the group consisting of metals or alloys having lower melting points than the target material, and a backing plate, said target material, said insert and said backing plate having a solid-phase diffusion bonded interfaces formed therebetween; and
(2-2) a method of manufacturing a sputtering target assembly characterised by solid-phase diffusion bonding of a target material of a given final shape having a melting point no less than 1000°C and a backing plate of a given final shape, with one or more insert interposed therebetween, said insert being made of one or more materials selected from the group consisting of metals or alloys having lower melting points than the target material, under a vacuum at a temperature between 200 and 600°C and at a pressure between 0.1 and 20 kg/mm².

The target material typically includes a refractory metal selected from the group consisting of W. Mo, Ti, Ta, Zr and Nb and its alloys. The insert typically consists of silver or silver alloys, copper or copper alloys, or nickel or nickel alloys.

In a combination of a titanium target material and a titanium backing plate, we have found that the solid-phase diffusion bonded is permitted with no use of insert.

There is described herein in a third aspect:
(3-1) a solid-phase diffusion-bonded sputtering target assembly characterised by being composed of a titanium target material and a backing plate of titanium, which have solid-phase diffusion bonding interfaces formed therebetween, said target material having a uniform crystal structure with a crystal grain diameter not exceeding 100 µm
This invention provides (3-2) a method of manufacturing a solid-phase diffusion bonded sputtering target assembly in which the target material has a uniform crystal structure with a crystal grain diameter of not exceeding 100 µm, characterised by solid-phase diffusion bonding of a titanium target material and a backing plate of titanium under conditions such that the strain rate attained is at most 1 x 10⁻³/sec., preferably at 350-650°C whereby the structure and crystal characteristics possessed by the titanium target before being diffusion bonded to the backing plate are maintained after diffusion bonding.

The solid-phase diffusion bonding of the target and backing plate, with or without one or more insert sandwiched therebetween at a low temperature and pressure causes interdiffusion of their constituent atoms to attain high adhesion and bond strength without attendant deterioration or deformation of the target material, while inhibiting the crystal grain growth in the target material. The bond thus obtained proves highly reliable because it undergoes no abrupt decrease in bond strength upon elevation of the service temperature and, owing to the solid phase bonding, 100% bonding is achieved with no un-bonded portions such as pores left along the interfaces.

### [BRIEF EXPLANATION OF THE DRAWINGS]

FIG. 1 is a perspective view of a sputtering target assembly consisting of a target material and a backing plate bonded through an insert by solid-phase diffusion bonding.

FIG. 2 is a graph comparing the bond strength values under shear at room temperature of a diffusion-bonded target assembly with those of the bonded material that used a low-melting brazing material of the Sn-Pb-Ag system in Example 1.

FIG. 3 is a graph showing the temperature dependence of the bond strength values under shear of the bonded materials of Example 1.

FIG. 4 is a micrograph showing the metallographic structure in the vicinity of bonded interfaces of an assembly consisting of an Al-1%Si-0.5%Cu target, Ag foil, and an OFC backing plate.

FIG. 5 is a micrograph showing the metallographic structure in the vicinity of bonded interfaces of an assembly consisting of a tungsten target and a titanium backing place bonded with an insert by solid-phase diffusion bonding.

FIG. 6 is a graph comparing the bond strength values under shear at room temperature of the solid-phase diffusion-bonded target assembly manufactured according to this invention with those of the assembly that used an In brazing metal in Example 6.

FIG. 7 is a micrograph showing the metallographic structure in the vicinity of the bond interface of an target assembly consisting of a titanium target solid phase diffusion-bonded to a backing plate of titanium.

### [Explanation of preferred embodiments]

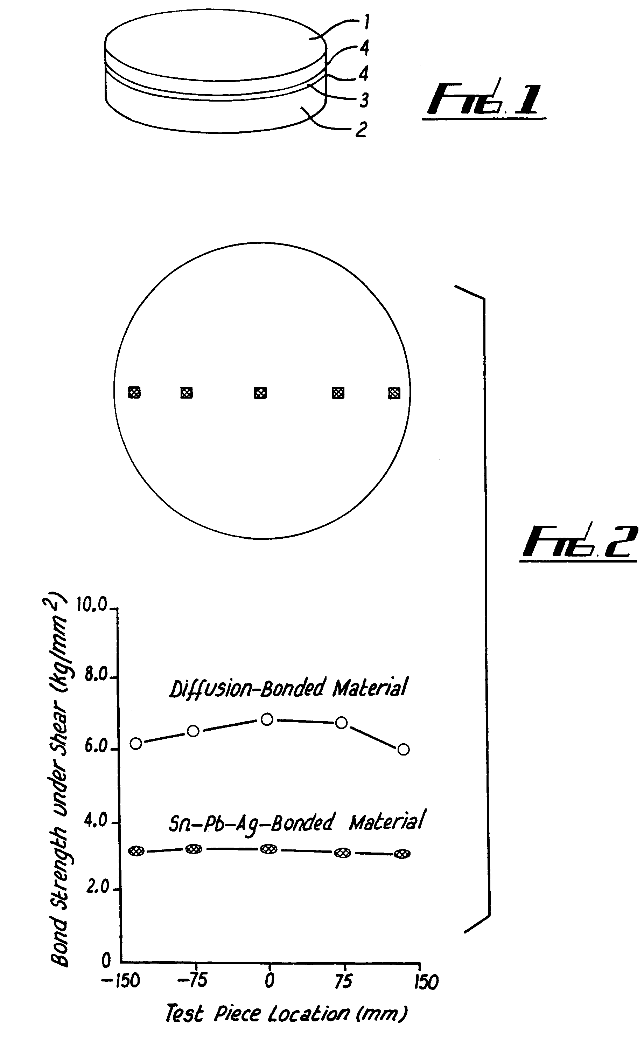

There is shown in FIG. 1 a diffusion-bonded sputtering target assembly manufactured by diffusion-bonding a target material 1 and a backing plate 2 through an insert 3 in accordance with this invention. The components are solidly bonded together with solid-phase diffusion-bonded interfaces 4. The insert 3 may be omitted depending upon a combination of the target material and the backing plate. In this case, the target material 1 and the backing plate 2 directly form their solid-phase diffusion-bonded interface. The target material maintains -the metallurgical characteristics and properties that it had before diffusion bonding.

There are described herein many kinds of target materials. For convenience in explanation, an explanation will be made dividing target materials with the melting point of 1000°C as a measure. Both target materials having melting points of no more than 1000°C and target materials having melting points of beyond 1000°C are described.

Typical examples of target materials having a melting point no more than 1000°C are aluminum and aluminum alloys such as Al-Si-Cu, Al-Si, and Al-Cu alloys. Other alloy targets composed principally of such metals as Cu or Au also come within the contemplation of this group. As for insert materials, Ag, Cu, Ni, or their alloys are usually used. One or more such insert materials may be used in layers.

Examples of target materials having a melting point above 1000°C are target materials of refractory metals and their alloys, such as W, Mo, Ti, Ta, Zr, Nb, and W-Ti, and of high-melting compounds, such as high-melting silicides (MoSiₓ, WSiₓ , etc.). The material to be used as an insert herein is one or more of metals or alloys having a melting point lower than that of the target material. Typical of insert materials is Ag, Cu, Ni, or their alloy. For solid-phase diffusion bonding, the use of an insert material having a lower melting point than the target material employed is essential.

In the combination of a titanium target material and a titanium backing plate, the solid-phase diffusion-bonding is permitted with no use of an insert. As the titanium target materials, high-purity titanium target materials having a purity of 99.99% or upward are preferable. Titanium backing plates may be of ordinary industrial purity. For the purposes of the invention the term "titanium" is used to encompass the alloys with small percentages, up to 10% by weight, of alloying additives such as Al, V, and Sn.

In fabricating a sputtering target assembly with the use of insert(s), a backing plate and a target material are degreased and rinsed with an organic solvent like acetone. Then, between the two is interposed an insert of one or more materials chosen from among Ag, Cu, Ni, and their alloys, desirably having at least 10 µm thickness. The insert too must be degreased and rinsed beforehand. The use of a 10 µm or thicker insert is desirable because the micropores that result from surface irregularities, on the order of several micrometers, caused by machining of the surfaces of the target and backing plate to be bonded, would otherwise lessen the adhesive strength. The upper limit of thickness of the insert is not specified provided the insert is thick enough for solid-phase diffusion bonding. Excessive thickness is wasteful, however. A conventional foil, thin sheet or the like may be employed. For the material of the insert, Ag, Cu, Ni, or their alloy is suitable as referred to above, by reason of moderately high melting point and diffusionability to permit solid phase diffusion bonding. The insert is not limited to a single layer. Two or more superposed layers may be used instead. The surfaces to be bonded should be free from oxides or other impurities.

In the case of a target materials having a melting temperature no more than 1000°C, a laminate consisting of a target material, a backing plate, and an insert is generally diffusion-bonded in a solid state by holding it at a constant temperature within a bonding temperature range of 150-300°C, preferably of 150-250°C, under a vacuum of 0.1 Torr or below and at a pressure of 9.8-196 MPa (1.0-20 kg/mm²), preferably 29.4-98 MPa (3-10 kg/cm²). In this way a sputtering target assembly is obtained. To avoid the formation of oxides, the bonding desirably is carried out in a vacuum atmosphere of 0.1 Torr or below. The choice of load to be applied depends upon the bonding temperature and the materials to be used. For sufficient pressure bonding to produce interfacial diffusion, the load must be at least 9.8 MPa (1.0 kg/mm²). On the other hand, a load in excess of 196 MPa (20 kg/mm²) can damage the target material. The bonding temperature is set within 150-300°C for the following reasons. If it is below 150°C insufficient diffusion of atoms results in poor adhesion. If it exceeds 300°C crystal grain growth takes place in the target material. Moreover, because of the difference in thermal expansion rate, the target material and backing plate tend to warp or distort, leading to inadequate bonding.

In the case of target materials having melting points more than 1000°C, a laminate consisting of a target material, a backing plate, and an insert is generally diffusion-bonded in a solid state by holding it at a constant temperature within a bonding temperature range of 200-600°C under a vacuum of 0.1 Torr or below and at a pressure of 0.98-196 MPa (0.1-20 kg/mm²), preferably 29.4-98 MPa (3-10 kg/mm²). In this way a sputtering target assembly is obtained. It is to avoid the formation of oxides that the bonding is carried out in a vacuum atmosphere of 0.1 Torr or below. The choice of the applicable load depends on the bonding temperature and the materials to be used. For sufficient pressure bonding to produce interfacial diffusion, the load must be at least 0.98 MPa (0. 1 kg/mm²). On the other hand, a load in excess of 196 MPa (20 kg/mm²) can damage the target material. The bonding temperature is set within 200-600°C for the following reasons. If it is below 200°C insufficient diffusion of atoms results in poor adhesion. If it exceeds 600°C the crystal structure, mechanical properties and the like of the target material and/or backing plate can deteriorate. Moreover, because of the difference in thermal expansion rate, the target material and backing plate tend to warp or distort, leading to inadequate bonding.

In the case where a titanium target material and a titanium backing plate are used, a laminate consisting of a target material and a backing plate is generally diffusion-bonded in a solid state by holding it at a constant temperature within a bonding temperature range of 350-650°C, preferably of 450-600°C, under a vacuum of 0.1 Torr or below and a load of 0.98-196 MPa (0.1-20 kg/mm²), at a strain rate of 1 x 10⁻³/sec or below, preferably 1 x 10⁻⁴/sec or below. In this way a sputtering target assembly is obtained. To avoid the formation of oxides, the bonding desirably is carried out in a vacuum atmosphere of 0.1 Torr or below. The choice of applicable load depends on the bonding temperature and the materials to be used. For sufficient pressure bonding to produce interfacial diffusion, the load must be at least 0.98 MPa (0.1 kg/mm). On the other hand, a load in excess of 196 MPa (20 kg/mm²) can damage the target material. The bonding temperature is set desirably within the range of 350-650°C for the following reasons. If it is below 350°C insufficient diffusion of atoms results in poor adhesion. If it exceeds 650°C grain growth tends to occur in the target material. Controlling the strain rate is particularly important. A strain rate in excess of 1 x 10⁻³/sec would cause non-uniform straining inside the target and attendant partial structural changes. It could also result in a decrease in the bond strength at and along the diffusion bonding interface.

The sputtering target assembly thus obtained shows no deterioration of the target material, has bonded interfaces with a bonding area percentage of 100% produced by liquid phase-free solid phase diffusion bonding, and can satisfactorily be used even in a high-power sputtering system. In addition, the crystal grain size of the target material can be kept below a required standard, for example no more than 250 µm even for target materials having melting points of no more than 1000°C and no more than 100 µm for an assembly of titanium target material and titanium backing plate, and uniform sputtering can be ensured. To reduce the adsorbed water, gas and the like on the target surface, it is possible to bake the target itself at about 200°C before use unlike the case where a low-melting brazing filler metal is used.

Further explanations will be made with the Examples. The Examples set forth herein are merely for illustration and do not intend the restriction of this invention.

### (Example 1)

An Al-1%Si-0.5% Cu target material in the form of a disk 300 mm in diameter and an oxygen-free copper (OFC) backing plate of the same size were ultrasonically degreased and rinsed with acetone. An insert of Ag foil 100 µm thick was used. The insert, after the ultrasonic degreasing and rinsing with acetone, was sandwiched between the Al-1%Si-0.5%Cu target material and the OFC backing plate.

The laminate consisting of the A1-1%Si-0.5%Cu target material, Ag foil insert, and OFC backing plate was diffusion-bonded in a vacuum of 5 x 10⁻⁵ Torr, at a bonding temperature of 250°C and under a load of 78.4 MPa (8 kg/mm²). The grain size of the target after the bonding was 150 µm.

Solid-phase diffusion bonding was performed similarly but changing the bonding temperature alone to 350°C. The grain size was now 400 µm.

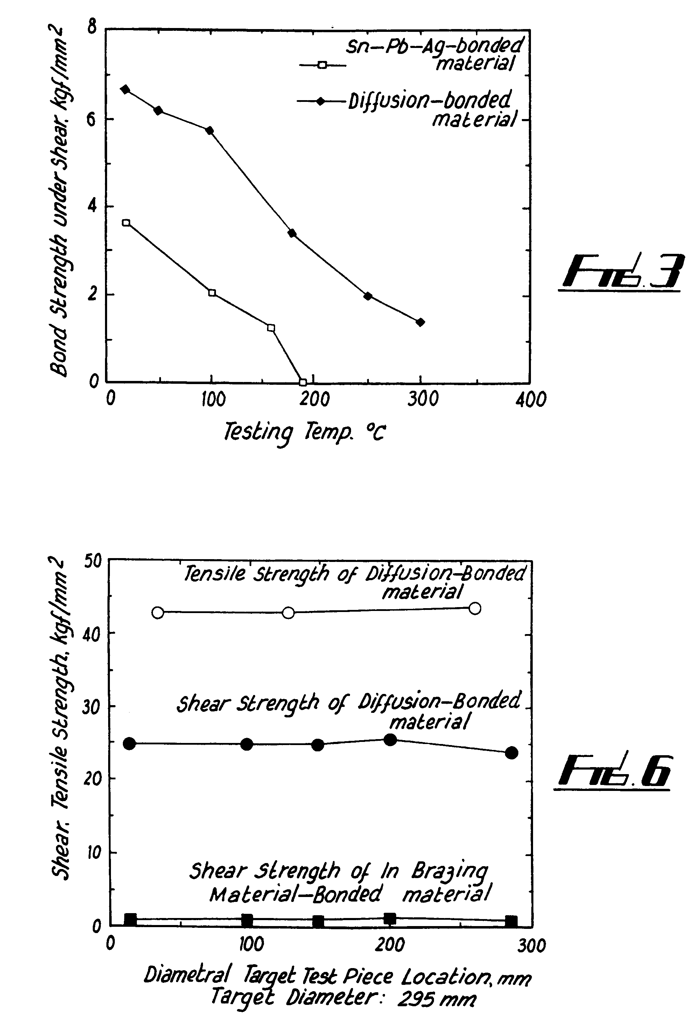

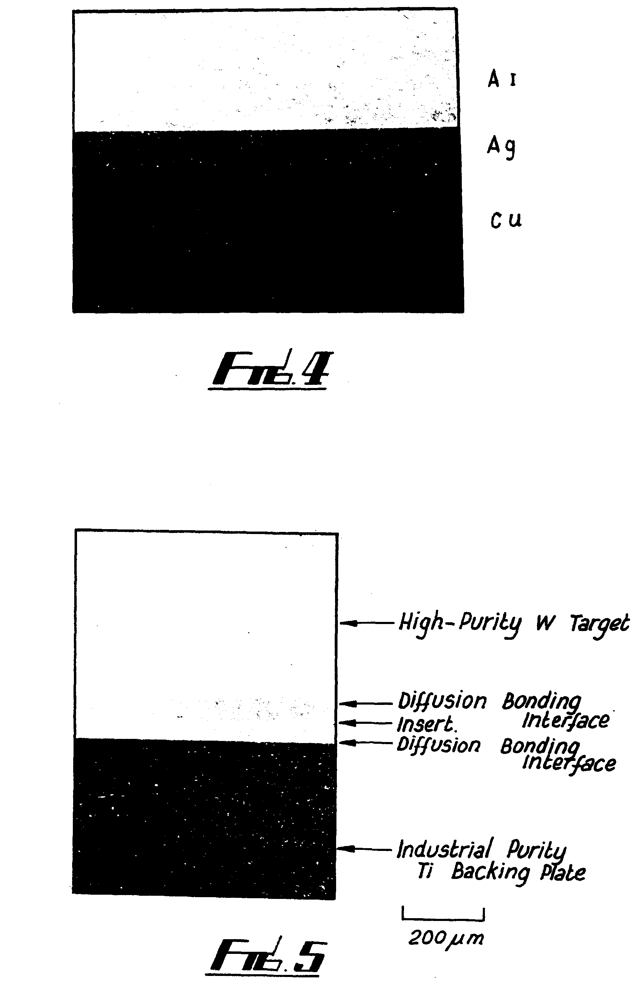

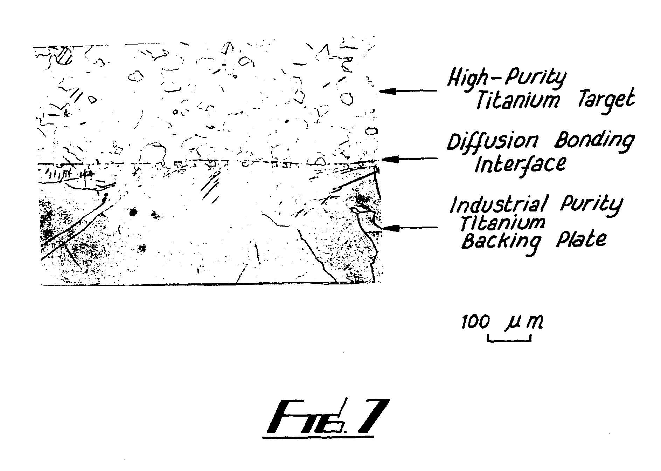

The bond strength values under shear at room temperature of test pieces cut out of five different diametral points of the diffusion-bonded material are compared, in FIG. 2, with those of corresponding test pieces of a laminate consisting of the same Al-1%Si-0.5%Cu target material and OFC backing plate similarly bonded but with an ordinary low-melting brazing material of the Sn-Pb-Ag system. FIG. 3 shows the temperature dependence of the bond strength values under shear of these bonded materials. As is obvious from FIGs. 2 and 3, the bond strength under shear of the laminate using the Sn-Pb-Ag low-melting brazing material is about 29.4 MPa (3 kg/mm²), while the material solid-phase diffusion-bonded in accordance with this example has about twice the strength, the values being around 58.8 MPa (6 kg/mm²). As for the temperature dependence, the bond strength under shear of the material using the Sn-Pb-Ag low-melting brazing material becomes zero in the vicinity of 180°C which is the melting point of the brazing material itself. The solid-phase diffusion-bonded material of this example, by contrast, exhibits a bond strength under shear of 29.4 MPa (3 kg/mm²) or more above 200°C and retains a strength of 19.6 MPa (2 kg/mm²) even above 250°C. FIG. 4 is a micrograph of a cross section illustrating the bond interfaces and neighboring portions of a laminate composed of an Al-1%Si-0.5%Cu target, Ag foil, and OFC backing plate according to the present example.

### (Example 2)

Targets were made by solid-phase diffusion bonding in the same manner as described in Example 1 with the exception that inserts of copper foil or nickel foil were used instead. Similar effects were achieved.

### (Example 3)

A Ti target material in the form of a disk 300 mm in diameter and an oxygen-free copper (OFC) backing plate of the same size were ultrasonically degreased and rinsed with acetone. An insert of Ag foil 100 µm thick was used. The insert, after the ultrasonic degreasing and rinsing with acetone, was sandwiched between the Ti target material and the OFC backing plate.

The laminate consisting of the Ti target material, Ag foil insert, and OFC backing plate was diffusion-bonded in a vacuum of 5 x 10⁻⁵ Torr, at a bonding temperature of 250°C, and under a load of 78.4 MPa (8 kg/mm²).

Similarly in Example 1, the bond strength values under shear at room temperature of test pieces cut out of five different diametral points of the diffusion-bonded material are compared with those of corresponding test pieces of a laminate consisting of the same Ti target material and OFC backing plate similarly bonded but with an ordinary low-melting brazing material of the Sn-Pb-Ag system. A similar graph as in FIG. 2 was obtained. The temperature dependence of the bond strength values under shear of these bonded materials was similar as in FIG. 3. The bond strength under shear of the laminate using the Sn-Pb-Ag low-melting brazing material is about 29.4 MPa (3 kg/mm²), while the material solid-phase diffusion-bonded in accordance with this invention has about twice the strength, the values being around 58.8 MPa (6 kg/mm²). As for the temperature dependence, the bond strength under shear of the material using the Sn-Pb-Ag low-melting brazing material becomes zero in the vicinity of 180°C of which is the melting point of the brazing material itself. The solid-phase diffusion-bonded material of this invention, by contrast, exhibits a bond strength under shear of 58.8 MPa (3 kg/mm²) or more above 200°C and retains a strength of 19.6 MPa (2 kg/mm²) even at 250°C.

### (Example 4)

A tungsten target material of high purity (>99.999%) in the form of a disk 295 mm in diameter was diffusion-bonded to a titanium backing plate of industrial purity through an Ag insert in a vacuum of 5 x 10⁻⁵ Torr, at a bonding temperature of 400°C, and under a load of 78.4 MPa (8 kg/mm²). A micrograph of a cross section illustrating the bond interfaces of the bonded material thus obtained is shown in FIG. 5. It can be seen from the photograph that interfaces having the bonded area percentage of 100% with non-bonded portions such as pores were obtained. The bond strength under shear at room temperature of test pieces cut out from five diametral points in the manner described in Example 3 was 68.6 MPa (7 kg/mm²). On the other hand, the bond strength under shear of test pieces of a material bonded using an In brazing material was at a level of as low as 9.8 MPa (1 kg/mm²). This difference verifies the superiority of solid-phase diffusion bonding.

### (Example 5)

Targets were made by solid-phase diffusion bonding similarly to Example 3 but using inserts of copper foil or nickel foil. Similar effects were attained.

### (Example 6)

A high-purity (>99.999%) titanium target in the form of a disk 295 mm in diameter was diffusion-bonded to a titanium backing plate of industrial purity directly without the use of an insert under a vacuum of 5 x 10⁻⁵ Torr and at a bonding temperature of 550°C, load of 73.5 MPa (7.5 kg/mm²), and strain rate of 2 x 10⁻⁵/sec. In FIG. 6 are compared the bond strength under shear at room temperature of an assembly made by solid-phase diffusion bonding in accordance with this invention with that of a assembly which used an In brazing material. A micrograph of the bond interface of the bonded assembly is shown in FIG. 7. The crystal grain size of the target after bonding was 50 µm. The photograph clearly indicates that the interface had attained 100% bonding without non-bonded portions such as pores. The test piece at room temperature exhibited a bond strength under shear of 245 MPa (25 kg/mm²) and a tensile strength under shear of 421 MPa (43 kg/mm²). The In brazing material-bonded piece gave a bond strength under shear at a low level of 9.8 MPa (1 kg/mm²). This testifies to the superiority of solid-phase diffusion bonding.

### (Example 7)

A target assembly was made by solid-phase diffusion bonding in the same manner as described in Example 6 with the exception that the bonding temperature was changed to 500°C and the strain rate to 1 x 10⁻⁵/sec. Similar effects were achieved.

### [Advantages of the invention]

Solid-phase diffusion bonding at a low temperature and pressure has the following features:
(1) The uniformity of crystal structure is maintained with the suppression of crystal grain growth.
(2) The process of fabrication causes no damage to the target material.
(3) Interdiffusion of the atoms constituting the target material, backing plate, and insert if used across the bond interfaces produces high degrees of adhesion and bond strength.
(4) The sharp drop of bond strength is avoided as found in the rise of the service temperature that can occur with a low-melting brazing material.
(5) Solid-phase bonding gives reliable bonds of a bonding area percentage of 100% without non-bonded portions such as pores that can result from ordinary bonding, due to shrinkage on solidification of a brazing material.

Consequently, this invention offers advantages as follows:
(a) A target material can be bonded to a backing plate without the possible danger of being damaged ; (b) uniformity of sputtering is ensured with the result that the film thickness is kept constant and the film properties are made uniform and stable; (c) a greater electric power can be put for sputtering, and therefore the throughput for film forming by sputtering can be improved; and (d) the target itself can be baked at around 200°C, thus reducing adsorbed water, gas, and the like in the target surface.

## Claims

1. A method of manufacturing a sputtering target assembly composed of a target of titanium and a backing plate of titanium comprising laminating the titanium target of a given final shape and the titanium backing plate of a given final shape, and solid-phase diffusion bonding the titanium target to the titanium backing plate under conditions such that the strain rate attained is no greater than 1x10⁻³/sec, whereby the structure and crystal characteristics possessed by the titanium target before being diffusion bonded to the backing plate are maintained after diffusion bonding, and the titanium target of the target assembly has uniform crystal structure with a crystal grain diameter not exceeding 100 µm.

2. A method according to claim 1 in which the diffusion bonding is performed at a temperature of between 350 and 650°C.

## Patentansprüche

1. Verfahren zum Herstellen einer Kathodenzerstäubungstarget-Anordnung mit einem Target aus Titan und einer Rückplatte aus Titan, wobei das Titan-Target einer gegebenen endgültigen Gestalt und die Titan-Rückplatte einer gegebenen endgültigen Gestalt laminiert werden und das Titan-Target mit der Titan-Rückplatte unter derartigen Bedingungen mittels Feststoffphasen-Diffusion verbunden wird, dass die erzielte Umformgeschwindigkeit (Dehnungsrate) nicht größer als 1x10⁻³/s ist, wodurch die Struktur und die Kristalleigenschaften, die das Titan-Target vor dem Diffusionsverbinden mit der Rückplatte besitzt, nach dem Diffusionsverbinden beibehalten werden, wobei das Titan-Target der Target-Anordnung eine gleichförmige Kristallstruktur hat, deren Kristallkorn-Durchmesser 100 µm nicht übersteigt.

2. Verfahren nach Anspruch 1, dadurch gekennzeichnet, dass das Diffusionsverbinden bei einer Temperatur zwischen 350°C und 650°C durchgeführt wird.

## Revendications

1. Procédé de fabrication d'un ensemble formant cible de pulvérisation composé d'une cible en titane et d'une plaque de support en titane, comprenant le laminage de la cible en titane d'une forme finale donnée et de la plaque de support en titane d'une forme finale donnée, et la liaison par diffusion en phase solide de la cible en titane sur la plaque de support en titane dans des conditions telles que la vitesse de déformation atteinte ne soit pas supérieure à 1 x 10⁻³/sec, la structure et les caractéristiques cristallines possédées par la cible en titane, avant d'être liée par diffusion à la plaque de support, étant maintenues après la liaison par diffusion et la cible en titane de l'ensemble formant cible présentant une structure cristalline uniforme, avec un diamètre de grains cristallins n'excédant pas 100 µm.

2. Procédé selon la revendication 1, dans lequel la liaison par diffusion est réalisée à une température comprise entre 350 et 650°C.
